# FASCICULE DE BREVET EUROPEEN

(11) **EP 0 869 618 B1**
(45) Date de publication et mention de la délivrance du brevet: **07.06.2006**
(21) Numéro de dépôt: 98200954.0
(22) Date de dépôt: 26.03.1998
(51) Int. Cl.: H03L 7/00

(54) **Dispositif de resynchronisation**
Synchronisierungsschaltung
Synchronisation circuit

(30) Priorité: 02.04.1997 FR 9703999; 17.09.1997 FR 9711580
(43) Date de publication de la demande: 07.10.1998
(73) Titulaire: Koninklijke Philips Electronics N.V., 5621 BA Eindhoven (NL)
(72) Inventeur: Vorenkamp, Pieter, 75008 Paris (FR); Marie, Hervé, 75008 Paris (FR)
(74) Mandataire: van Oudheusden-Perset, Laure E.

(56) Documents cités:
- EP-A- 0 716 501
- US-A- 5 220 581
- US-A- 5 245 637
- "programmable interface receiver" IBM TECHNICAL DISCLOSURE BULLETIN, vol. 38, no. 4, 1 avril 1995, NEW YORK,US, pages 597-599, XP000516266

## Description

La présente invention concerne un circuit intégré comportant, entre autres, un module dit de resynchronisation présentant une entrée d'horloge pour un signal d'horloge, une entrée de signal pour un signal de données d'entrée, et une sortie, module muni d'une bascule de type D dont l'entrée de signal est reliée à l'entrée de signal du module et dont l'entrée d'horloge est reliée à l'entrée d'horloge du module.

Elle concerne également un dispositif d'affichage à cristaux liquides.

L'invention s'applique lorsqu'on a besoin de deux signaux dont les fréquences sont multiples l'une de l'autre et dont les transitions soient parfaitement en phase. Elle s'applique, entre autres, à une interface pour écran à cristaux liquides, pour générer la fréquence pixel à partir du signal d'horloge lignes.

Un module de synchronisation peut être constitué par une simple bascule de type D. Un arrangement plus sophistiqué, muni d'une bascule D dont l'entrée de signal et l'entrée d'horloge constituent les entrées homonymes de l'arrangement, est décrit dans le document EP 0 716 501. Cet arrangement délivre, à partir d'un signal et d'une horloge, une première et une seconde indications de détection d'une transition du signal, ces deux indications étant identiques entre elles lorsque l'horloge est en phase avec le signal. Un autre arrangement est connu du document « IBM TECHNICAL DISCLOSURE BULLETIN, Vol.38, num.4, 1^{er} avril 1995, pages 597-599 ». Cet autre arrangement met notamment en oeuvre une première bascule de type D recevant un signal de données d'entrée et délivrant un signal de sortie, un commutateur de signal pour délivrer à une deuxième bascule de type D soit ledit signal de sortie soit ledit signal de données d'entrée.

Un objet de l'invention est d'obtenir un montage qui, à partir d'un signal d'entrée et d'un signal d'horloge, délivre un signal identique au signal d'entrée mais synchronisé avec le signal d'horloge, et ceci même lorsqu'un front du signal d'horloge est en quasi-coincidence avec un front du signal (dans un tel cas, avec une simple bascule de type D, le changement d'état ne peut pas être anticipé, et le front risque d'être manqué).

A cet effet, pour délivrer à sa sortie, à partir du signal d'entrée et du signal d'horloge, un signal identique au signal d'entrée mais synchronisé avec le signal d'horloge, le module de resynchronisation comprend une seconde bascule de type D dont l'entrée d'horloge est reliée à celle de la première bascule via un inverseur et dont la sortie est reliée à la sortie du module, et la sortie de la première bascule est reliée à l'entrée de signal de données de la seconde bascule via un multiplexeur, commandé par un signal numérique de commande contenant une information sur la relation de phase entre le signal de données à l'entrée et le signal d'horloge, de façon à appliquer à la seconde bascule soit le signal de données d'entrée soit le signal issu de la première bascule.

Dans une application particulière, le circuit intégré comporte en outre un dispositif multiplieur de fréquence du type dit PLL, suivi d'un déphaseur muni :
- d'une entrée reliée à la sortie du dispositif multiplieur,
- d'une sortie
- et de moyens pour délivrer sur cette sortie un signal décalé en phase par rapport au signal sur son entrée,
le dispositif multiplieur comprenant :
- un oscillateur muni d'une sortie pour fournir un signal dont la fréquence est réglable par une tension appliquée à une entrée de réglage,
- un diviseur de fréquence muni d'une entrée reliée à la sortie de l'oscillateur et d'une sortie pour fournir un signal dont la fréquence est divisée par rapport à celle du signal d'oscillateur, et
- un comparateur de phase muni de deux entrées, dont l'une est destinée à recevoir un signal de référence et l'autre est reliée à la sortie du diviseur, et d'une sortie reliée à l'entrée de réglage de l'oscillateur,
l'entrée d'horloge du module de resynchronisation étant reliée à la sortie du déphaseur et son entrée de signal étant reliée à la sortie du diviseur.

Actuellement, un dispositif d'affichage à cristaux liquides comprend en général une ligne à retard programmable afin de pouvoir régler la phase du signal de synchronisation lignes, ce qui permet d'optimiser l'instant d'échantillonnage des signaux vidéo, ligne à retard suivie d'un circuit oscillateur à boucle asservie en phase, dit PLL, pour générer l'horloge pixel par multiplication de la fréquence lignes.

Un tel dispositif comporte avantageusement un circuit intégré selon l'invention, avec un multiplieur de fréquence du type dit PLL, le déphaseur associé et le module de resynchronisation, l'entrée du multiplieur étant reliée à une connexion portant un signal de synchronisation lignes, afin de générer d'une part un signal à fréquence pixel, à partir du signal de synchronisation lignes, et d'autre part un nouveau signal de synchronisation lignes synchronisé sur le signal à fréquence pixel.

Ainsi le contrôle de la phase de l'horloge pixel est réalisé après la multiplication de fréquence, contrairement aux systèmes connus, où le retard est introduit avant la multiplication de fréquence. Ceci est rendu possible par l'utilisation d'un module de resynchronisation selon l'invention et permet à la fois de simplifier la réalisation d'ensemble du dispositif d'affichage à cristaux liquides et d'améliorer ses performances.

De préférence, dans le dispositif, muni de moyens pour traiter des signaux de couleur et comprenant un convertisseur analogique/numérique pour chaque signal de couleur, le signal à fréquence pixel issu du déphaseur est fourni à ce convertisseur analogique/numérique pour en commander les instants d'échantillonnage.

Ces aspects de l'invention ainsi que d'autres aspects plus détaillés apparaîtront plus clairement grâce à la description suivante d'un mode de réalisation constituant un exemple non limitatif.
La figure 1 est un schéma d'une partie de circuit intégré utilisant un module de resynchronisation selon l'invention, associé avec un dispositif comprenant une boucle de contrôle de phase.
La figure 2 représente plus en détail un module de resynchronisation.
La figure 3 représente schématiquement un dispositif d'affichage en couleurs à cristal liquide, pour ordinateur.

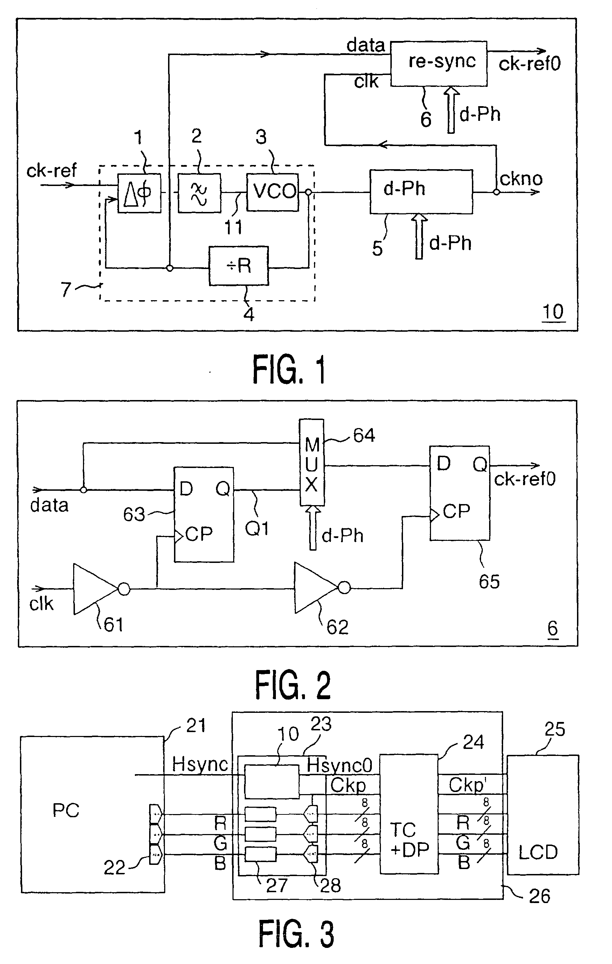

La partie de circuit intégré 10 représentée par la figure 1 délivre deux signaux dont l'un est à une fréquence multiple de celle de l'autre, dont les transitions sont parfaitement en phase, et dont le déphasage par rapport à une horloge reste constant lorsque la fréquence des signaux varie. Il comporte une boucle à contrôle de phase 7, dite PLL, comprenant :
- un oscillateur 3, à fréquence réglable au moyen d'une tension appliquée sur une connexion 11, et dont la sortie fournit un signal d'oscillateur.
- un diviseur 4 qui divise en fréquence dans un rapport R le signal d'oscillateur.
- un comparateur de phase 1 qui compare la phase des signaux appliqués à l'une et l'autre de ses deux entrées, dont l'une est reliée à un signal de référence "ck-ref" et l'autre est reliée à la sortie du diviseur de fréquence 4. Le signal de comparaison fourni par ce comparateur est appliqué via un filtre passe-bas 2 à la connexion 11, pour régler la fréquence de l'oscillateur 3.

Le dispositif comporte en outre un déphaseur 5 dont le déphasage est programmable. Ce déphaseur a une entrée reliée au signal d'oscillateur, et il délivre sur sa sortie "ckno" un signal décalé en phase par rapport au signal d'entrée, la grandeur de ce décalage étant commandée par un signal numérique de commande d-Ph.

Le dispositif comporte enfin un module 6 de resynchronisation qui sera décrit plus en détail à propos de la figure 2 ; ce module comprend :
- une entrée d'horloge "clk" qui est reliée à la sortie du déphaseur 5,
- une entrée de signal "data" qui est reliée à la sortie du diviseur 4,
- une sortie qui constitue une sortie "ck-ref0" du dispositif, et
- une entrée pour le signal numérique d'information d-Ph.

Le signal "d-Ph" commande donc d'une part la valeur du déphasage désiré dans le déphaseur, et d'autre part le module de resynchronisation 6.

Le module de resynchronisation 6 est représenté par la figure 2, les mêmes bornes portant les mêmes références que dans la figure 1. Ce module présente les mêmes entrées et sortie qu'une bascule de type D, à savoir, une entrée "data" destinée à recevoir des données, une entrée "clk" destinée à recevoir un signal d'horloge et une sortie "ck-ref0", destinée à délivrer des données échantillonnées.

Le module comprend une première bascule 63 de type D, et une seconde bascule 65 du même type. L'entrée d'horloge de la bascule 63 reçoit le signal d'horloge "clk". Ici un inverseur 61 est intercalé entre l'entrée d'horloge CP de la bascule et l'entrée d'horloge "clk" ; cet inverseur n'est pas toujours nécessaire, cela dépend du signe de l'horloge clk disponible. L'entrée d'horloge de la bascule 65 reçoit la même horloge, après une seconde inversion dans un inverseur 62. L'entrée de signal de données de la bascule 63 est reliée à l'entrée "data" du module. La sortie de la bascule 65 constitue la sortie "ck-ref()" du module et son entrée est reliée à la sortie d'un multiplexeur 64. Ce dernier est commandé par le signal d-Ph contenant une information sur la relation de phase entre le signal à l'entrée "data" et celui à l'entrée "clk", ce qui a pour effet de sélectionner soit le signal de données de l'entrée "data", soit le signal Q1 issu de la bascule 63. Lorsque les signaux "data" et "clk" sont en coïncidence, le signal "data" est d'abord synchronisé dans la bascule 63 sur un front descendant de l'horloge, ce qui donne le signal Q1, qui est resynchronisé dans la bascule 65 sur un front montant de l'horloge. Lorsque "data" et "clk" ne sont pas en coïncidence, ce qui est indiqué par une valeur particulière du signal d-Ph, le multiplexeur 64 sélectionne le signal à l'entrée "data", signal qui est alors resynchronisé par la bascule 65. Bien que synchrones, les signaux "clk" et "ck-ref0" ne sont pas, en général, à la même fréquence : l'horloge est par exemple à une fréquence multiple de celle du signal de données.

Le signal d-Ph peut être créé spécifiquement pour être fourni à ce module, par exemple à l'aide d'un arrangement dérivé de celui décrit par le document mentionné plus haut, qui détecte si des signaux sont en phase. Néanmoins dans la plupart des cas ceci n'est pas nécessaire, car un signal adéquat est déjà présent dans une autre partie du circuit : c'est le cas pour le circuit représenté par la figure 1, qui représente une application du module de la figure 2.

Un ordinateur comme celui référencé 21 sur la figure 3, par exemple de type dit "PC", comprend habituellement des convertisseurs numérique/analogique ultra-rapides, dont l'un est référencé 22, de façon à délivrer, à partir de signaux de couleur R, G, B, disponibles sous forme numérique dans l'ordinateur, des signaux analogiques destinés à un dispositif d'affichage de type quelconque. Des signaux de synchronisation ligne Hsync sont aussi fournis (ainsi que des signaux trame non représentés, qui ne sont pas traités par le circuit de l'invention).

Ici le dispositif d'affichage est du type à cristal liquide. Un module de commande 26 traite les signaux analogiques pour les adapter au module d'affichage à cristal liquide proprement dit 25, et est constitué :
- d'un circuit 24 de conversion de temps et de traitement numérique, connu en soi et qui, à partir d'un signal d'horloge pixel Ckp, d'un signal de synchronisation ligne Hsync0, et de signaux numériques de couleur, R, G, B, fournit une horloge Ckp' et des signaux de couleur R, G, B adaptés au module d'affichage à cristal liquide 25,
- et d'un circuit d'interface 23, qui comprend notamment:
   - sur chaque couleur
      - un circuit, dont l'un est référencé 27, comportant un moyen d'alignement du noir (clamp) et un amplificateur à gain réglable,
      - suivi d'un convertisseur analogique/numérique, dont l'un est référencé 28, délivrant des signaux de couleur R, G, B à nouveau sous forme numérique.
   - en ce qui concerne la synchronisation lignes, un circuit 10 qui est semblable à celui de la figure 1, délivrant deux signaux dont l'un est à une fréquence multiple de celle de l'autre et dont les transitions sont parfaitement en phase.

Dans le circuit 10, le diviseur 4 a un rapport de division égal au rapport entre la fréquence pixel et la fréquence Hsync, il reçoit à son entrée le signal Hsync (ck-ref sur la figure 1), et fournit à sa sortie :
- une horloge Ckp (ckno sur la figure 1), dont on peut faire varier la phase, et qui est amenée en outre aux convertisseurs analogique/numérique 28 pour commander leur instant d'échantillonnage, et
- un signal de synchronisation lignes Hsync0 (ck-ref0 sur la figure 1), resynchronisé sur le signal Ckp.

## Revendications

1. Circuit intégré comprenant un module de resynchronisation (6) présentant une première entrée pour recevoir un signal d'horloge (clk), une deuxième entrée pour recevoir un signal de données d'entrée (data), et une sortie pour délivrer un signal (ck-ref0) identique au signal de données d'entrée (data) et synchronisé avec le signal d'horloge (clk), ledit module (6) comprenant :
- une première bascule (63) de type D comprenant une entrée d'horloge (CP) reliée à ladite première entrée, une entrée de signal (D) reliée à ladite deuxième entrée, une sortie (Q) pour délivrer un signal de sortie (Q1),
- une deuxième bascule (65) de type D comprenant une entrée d'horloge (CP) pour recevoir un signal d'horloge modifié, une entrée de signal (D), une sortie (Q) pour délivrer ledit signal (ck-ref0),
- un multiplexeur (64) commandable par un signal numérique de commande (d-Ph) pour appliquer sur ladite entrée de signal (D) de la deuxième bascule (65) soit le signal de données d'entrée (data) soit le signal de sortie (Q1) de la première bascule (63), **caractérisé en ce que** le circuit intégré comprend un inverseur (62) pour recevoir ledit signal d'horloge (clk) et délivrer ledit signal d'horloge modifié, ledit signal numérique de commande (d-Ph) contenant une information sur la relation de phase entre le signal de données d'entrée (data) et le signal d'horloge (clk).

2. Circuit intégré selon la revendication 1 comprenant :
- un dispositif multiplieur de fréquence (7) du type PLL comprenant :
a) un oscillateur (3) muni d'une entrée de réglage et d'une sortie pour délivrer un signal d'oscillateur de fréquence réglable par une tension de réglage appliquée à ladite entrée de réglage,
b) un diviseur de fréquence (4) muni d'une entrée reliée à la sortie dudit oscillateur (3) et d'une sortie pour délivrer un signal de fréquence divisée par rapport à la fréquence dudit signal d'oscillateur,
c) un comparateur de phase (1) comprenant une première entrée pour recevoir un signal de référence (ck-ref) et une deuxième entrée pour recevoir ledit signal de fréquence divisée, et une sortie pour délivrer ladite tension de réglage via un filtre (2),
- un déphaseur (5) commandable par ledit signal numérique de commande (d-Ph) pour délivrer un signal (ckno) décalé en phase par rapport au dit signal d'oscillateur,
la première entrée du module (6) étant reliée à la sortie du déphaseur (5) et la deuxième entrée du module (6) étant reliée à la sortie du diviseur de fréquence (4).

3. Dispositif d'affichage à cristaux liquides comprenant un circuit intégré selon la revendication 2, l'entrée du dispositif multiplieur de fréquence (7) étant reliée à une connexion portant un signal de synchronisation lignes (Hsync), afin de délivrer d'une part un signal à fréquence pixel (Ckp) à la sortie du déphaseur (5), et d'autre part un signal de synchronisation lignes (Hsync0) à la sortie du module (6).

4. Dispositif d'affichage à cristaux liquides selon la revendication 3 comprenant des convertisseurs de type analogique / numérique (28) pour convertir des signaux de couleur (R, G, B), chaque convertisseur analogique / numérique étant muni d'une entrée d'horloge d'échantillonnage pour recevoir ledit signal à fréquence pixel (Ckp).

## Claims

1. An integrated circuit comprising a resynchronization module (6) having a first input for receiving a clock signal (clk), a second input for receiving an input data signal (data), and an output for supplying a signal (ck-ref0) which is identical to the input data signal (data) and is synchronized with the clock signal (clk), said module (6) comprising:
- a first D-type flip-flop (63) having a clock input (CP) coupled to said first input, a signal input (D) coupled to said second input, an output (Q) for supplying an output signal (Q1),
- a second D-type flip-flop (65) having a clock input (CP) for receiving a modified clock signal, a signal input (D), an output (Q) for supplying said signal (ck-ref0),
- a multiplexer (64) controllable by a digital control signal (d-Ph) for applying either the input data signal (data) or the output signal (Q1) from the first flip-flop (63) to said signal input (D) of the second flip-flop (65), **characterized in that** the integrated circuit comprises an inverter (62) for receiving said clock signal (clk) and supplying said modified clock signal, said digital control signal (d-Ph) containing information about the phase relationship between the input data signal (data) and the clock signal (clk).

2. An integrated circuit as claimed in claim 1, comprising:
- a frequency multiplier device (7) of the PLL type, comprising:
a) an oscillator (3) having a control input and an output for supplying an oscillator signal whose frequency is controllable by a control voltage applied to said control input,
b) a frequency divider (4) having an input coupled to the output of said oscillator (3) and an output for supplying a signal whose frequency has been divided with respect to the frequency of said oscillator signal,
c) a phase comparator (1) having a first input for receiving a reference signal (ck-ref) and a second input for receiving said frequency-divided signal, and an output for supplying said control voltage via a filter (2)
- a phase shifter (5) controllable by said digital control signal (d-Ph) for supplying a signal (ckno) which is shifted in phase with respect to said oscillator signal,
the first input of the module (6) being connected to the output of the phase shifter (5) and the second input of the module (6) being connected to the output of the frequency divider (4).

3. A liquid crystal display device including an integrated circuit as claimed in claim 2, wherein the input of the frequency multiplier device (7) is coupled to a connection conveying a line synchronization signal (Hsync) so as to supply, on the one hand, a signal of pixel frequency (Ckp) to the output of the phase shifter (5) and, on the other hand, a line synchronization signal (Hsync0) to the output of the module (6).

4. A liquid crystal display device as claimed in claim 3, including analog-to-digital converters (28) for converting color signals (R, G, B), each analog-to-digital converter having a sample clock input for receiving said signal of pixel frequency (Ckp).

## Patentansprüche

1. Integrierte Schaltung mit einem Modul zur erneuten Synchronisierung (6) mit einem ersten Eingang für den Erhalt eines Uhrsignals (clk), einem zweiten Eingang für den Erhalt eines Eingangsdatensignals (data),
und einem Ausgang für die Ausgabe eines Signals (ck-ref0), identisch mit dem Eingangsdatensignal (data) und synchronisiert mit dem Uhrsignal (clk), wobei das besagte Modul (6) enthält:
- Ein erstes Flipflop (63) vom Typ D mit einem Uhreingang (CP), verbunden mit dem besagten ersten Eingang, einem Signaleingang (D), verbunden mit dem besagten zweiten Eingang und einem Ausgang (Q) für die Ausgabe eines Ausgangssignals (Q1),
- ein zweites Flipflop (65) vom Typ D mit einem Uhreingang (CP) für den Erhalt eines veränderten Uhrsignals, einem Signaleingang (D) und einem Ausgang (Q) für die Ausgabe des besagten Signals (ck-ref0),
- einen Multiplexer (64), steuerbar durch ein digitales Steuersignal (d-Ph), um dem dem besagten Signaleingang (D) des zweiten Flipflops (65) entweder das Eingangsdatensignal (data) oder das Ausgangssignal (Q1) des ersten Flipflops (63) zuzuführen, **dadurch gekennzeichnet, dass** die integrierte Schaltung einen Inverter (62) für den Erhalt des besagten Uhrsignals (clk) und die Ausgabe des besagten veränderten Uhrsignals enthält,
wobei das besagte digitale Steuersignal (d-Ph) eine Information zum Phaseverhältnis zwischen dem Eingangsdatensignal (data) und dem Uhrsignal (clk) enthält.

2. Integrierte Schaltung gemäß Anspruch 1, die enthält:
- Eine Vorrichtung zur Frequenzmultiplizierung (7) vom PLL-Typ, die enthält:
a) Einen Oszillator (3) mit einem Regeleingang und einem Ausgang für die Ausgabe eines Oszillatorsignals mit über eine Regelungspannung an den besagten Regeleingang zugeführter regelbarer Frequenz,
b) einen Frequenzteiler (4) mit einem Eingang, verbunden mit dem Ausgang des besagten Oszillators (3), und einem Ausgang für die Ausgabe eines in Bezug auf die Frequenz des besagten Oszillatorsignals geteilten Frequenzsignals,
c) einen Phasenvergleicher (1) mit einem ersten Eingang für den Erhalt eines Referenzsignals (ck-ref) und einem zweiten Eingang für den Erhalt des besagten geteilten Frequenzsignals und einem Ausgang für die Ausgabe der besagten Regelungspannung über einen Filter (2),
- einen Phasenschieber (5), steuerbar von dem besagten digitalen Steuersignal (d-Ph) für die Ausgabe eines in Bezug auf das besagte Oszillatorsignal phasenverschobenen Signals (ckno),
wobei der erste Eingang des Moduls (6) mit dem Ausgang des Phasenschiebers (5) verbunden ist und der zweite Eingang des Moduls (6) mit dem Ausgang des Frequenzteilers (4) verbunden ist.

3. Anzeigevorrichtung mit Flüssigkristallen mit einer integrierten Schaltung nach Anspruch 2, wobei der Eingang der Vorrichtung zur Frequenzmultiplizierung (7) mit einem Anschluss verbunden ist, der ein Zeilensynchronisierungssignal (Hsync) trägt, um einerseits ein Pixelfrequenzsignal (Ckp) an den Ausgang des Phasenschiebers (5) und andererseits ein Zeilensynchronisierungssignal (Hsync0) an den Ausgang des Moduls (6) auszugeben.

4. Anzeigevorrichtung mit Flüssigkristallen nach Anspruch 3, mit Wandlern vom Typ analog/digital (28) zur Umwandlung von Farbsignalen (R, G, B), wobei jeder Analog/Digital-Wandler mit einem Abgreifuhreingang für den Erhalt des besagten Pixelfrequenzsignals (Ckp) ausgestattet ist.
